# EUROPÄISCHE PATENTSCHRIFT

(11) **EP 1 844 552 B1**
(45) Veröffentlichungstag und Bekanntmachung des Hinweises auf die Patenterteilung: **10.06.2009**
(21) Anmeldenummer: 05819362.4
(22) Anmeldetag: 13.12.2005
(51) Int. Cl.: H03M 3/04

(54) **DELTA-SIGMA-MODULATOR**
DELTA SIGMA MODULATOR
MODULATEUR DELTA-SIGMA

(30) Priorität: 26.01.2005 DE 102005003630
(43) Veröffentlichungstag der Anmeldung: 17.10.2007
(73) Patentinhaber: ROBERT BOSCH GMBH, 70442 Stuttgart (DE)
(72) Erfinder: WILLIG, Rainer, 71732 Tamm (DE); KUHLMANN, Burkhard, 72800 Eningen (DE); GOMEZ, Udo-Martin, 71229 Leonberg (DE); BAUER, Wolfram, 72074 Tuebingen (DE); NEUL, Reinhard, 70567 Stuttgart (DE); LANG, Christoph, Palo Alto, 94304 (CA); VEITH, Michael, 72766 Reutlingen (DE)
(86) Internationale Anmeldenummer: PCT/EP2005/056743
(87) Internationale Veröffentlichungsnummer: WO 2006/079435

(56) Entgegenhaltungen:
- US-A1- 2004 169 437
- US-B1- 6 232 899
- JIANGFENG WU ET AL: "A simulation study of electromechanical delta-sigma modulators" ISCAS 2001. PROCEEDINGS OF THE 2001 IEEE INTERNATIONAL SYMPOSIUM ON CIRCUITS AND SYSTEMS. SYDNEY, AUSTRALIA, MAY 6 - 9, 2001, IEEE INTERNATIONAL SYMPOSIUM ON CIRCUITS AND SYSTEMS, NEW YORK, NY : IEEE, US, Bd. VOL. 1 OF 5, 6. Mai 2001 (2001-05-06), Seiten 453-456, XP010541174 ISBN: 0-7803-6685-9

## Beschreibung

### Stand der Technik

Die Erfindung geht aus von einem Delta-Sigma-Modulator, mit einem schwingfähigen System mit einer Eigenfrequenz, mit einer Elektronik und mit einer Regelschleife, die von dem schwingfähigen System auf die Elektronik und von der Elektronik wieder auf das schwingfähige System wirkt.

Mikrosysteme in denen mikromechanische Sensoren mit einer Auswerteelektronik kombiniert werden sind Schlüsselkomponenten für moderne Systeme im KFZ wie zum Beispiel ESP, Airbag-Steuerung, Roll-Over-Sensierung und Navigation.
Eine mit vielen Vorteilen verbundene Möglichkeit, das mikromechanische Sensorelement mit einer mikroelektronischen Auswerteelektronik zu kombinieren, besteht im Aufbau eines elektromechanischen ΔΣ-Modulators.

In den Schriften "Surface Micromachined Accelerometers", Bernhard E. Boser, Roger T. Howe, IEEE Journal of Solid State Circuits, Vol. 31, No. 3, March 1996 und C. Lang "Modellbildung und Realisierung eines rauscharmen elektromechanischen ΔΣ-Modulators zur Beschleunigungsmessung nach dem Prinzip der Kraftkompensation", Shaker-Verlag, Aachen, 2001, ISBN 3-8265-8616-6 sind elektromechanische Delta-Sigma-Modulatoren im Stand der Technik beschrieben.

Die Druckschrift Jiangfeng Wu et al: "A simulation study of electromechanical delta-sigma modulators", ISCAS 2001. Proceedings of the 2001 IEEE international symposium on circuits and systems. Sydney, Australia, May 6-9, 2001, IEEE International symposium on circuits ands systems, New York, NY: IEEE, US, Bd. Vol. 1 of 5, 6. Mai 2001 (2001-05-06), Seiten 453-456, XP010541174, ISBN: 0-7803-6685-9, beschreibt elektromechanische Delta-Sigma-Modulatoren, welche mechanische Kräfte als Eingang aufweisen und mikromechanische Transducer in den Schleifen aufweisen. In der Schrift wird vorgeschlagen, ein sogenanntes komplementäres pulsdichtenmoduliertes Signal (CPDM-Signal) zu verwenden, um mittels Mikroaktuatoren eine lineare Multibitrückkopplung zu erzielen.

### Vorteile der Erfindung

Die Erfindung geht aus von einem Delta-Sigma-Modulator, mit einem schwingfähigen System mit einer Eigenfrequenz, mit einer Elektronik und mit einer Regelschleife, die von dem schwingfähigen System auf die Elektronik und von der Elektronik wieder auf das schwingfähige System wirkt. Der Kern der Erfindung besteht darin, dass die Regelschleife derart ausgestaltet ist, dass eine Verstärkung in der Regelschleife eine Verstärkungsüberhöhung in einem Frequenzbereich um die Eigenfrequenz des schwingfähigen Systems aufweist. Vorteilhaft lässt sich hierbei das Quantisierungsrauschen der Elektronik in Abhängigkeit von der Frequenz des Signals in der Regelschleife formen.

Eine vorteilhafte Ausgestaltung der Erfindung sieht vor, dass das schwingfähige System mechanisch ausgestaltet ist. Vorteilhaft können bei einem solchen System die Funktionen eines Messwertaufnehmers, insbesondere für Beschleunigungen oder Drehraten, mit der Funktion eines Bausteins, nämlich eines Integrierers zum Formen des Quantisierungsrauschens, in einem Delta-Sigma-Modulator kombiniert werden. Im elektromechanischen Delta-Sigma-Modulator wird vorteilhaft das integrierende Verhalten der Mechanik ausgenutzt, um das Quantisierungsrauschen des ADU und des DAU zu formen. Die Mechanik reagiert auf eine (Coriolis-)Beschleunigung mit einer Auslenkung einer beweglichen Masse. Die Übertragungsfunktion von Beschleunigung nach Auslenkung beinhaltet zwei Integrierer. Ein Integrierer beschreibt die Wandlung von Beschleunigung in die Geschwindigkeit der beweglichen Masse. Der zweite Integrierer beschreibt die Wandlung von Geschwindigkeit in Auslenkung. In rein elektronischen Delta-Sigma-Modulatoren werden dazu im Unterschied rein elektronische Integrierer (meistens Switched-Capacitor-Schaltungen) eingesetzt, um das Quantisierungsrauschen des DAU zu formen.

Vorteilhaft ist, dass der Delta-Sigma-Modulator an einem Ausgang eine Bandpasscharakteristik aufweist. Vorteilhaft ist der erfindungsgemäße Delta-Sigma-Modulator mit Bandpasscharakteristik geeignet, um Signale mit einer bestimmten oder bekannten Bandbreite zu verarbeiten wie beispielsweise eine Trägerfrequenz mit aufmodulierten Signalen.

Vorteilhaft ist, dass die Elektronik einen Analog-Digital-Umsetzer (ADU), einen Digital-Analog-Umsetzer (DAU) und Mittel zur Einstellung der Verstärkung in der Regelschleife und/oder der Bandbreite des Delta-Sigma-Modulators unabhängig von einem Eingangssignal des Analog-Digital-Umsetzers (ADU) beinhaltet.

Eine vorteilhafte Ausgestaltung des erfindungsgemäßen ΔΣ-Modulators sieht vor, dass die Elektronik einen Multibit-Analog-Digital-Umsetzer und/oder einen Multibit-Digital-Analog-Umsetzer beinhaltet. Vorteilhaft kann hierdurch am Analog-Digital-Umsetzer eine definierte Verstärkung eingestellt werden, welche unabhängig vom Eingangssignal des Analog-Digital-Umsetzers ist. Vorteilhaft kann weiterhin der Quantisierungsfehler des Analog-Digital-Umsetzers klein gehalten werden. Dieselben Vorteile gelten sinngemäß für den Digital-Analog-Umsetzer.

Eine weitere vorteilhafte Ausgestaltung des erfindungsgemäßen ΔΣ-Modulators sieht vor, dass die Elektronik ein Tiefpassfilter mit Güteüberhöhung, insbesondere ein digitales Filter enthält, derart dass der ΔΣ-Modulator eine Bandpasscharakteristik mit einer Bandmittenfrequenz bei der Eigenfrequenz des schwingfähigen Systems aufweist. Vorteilhaft kann hierdurch die Bandbreite unabhängig vom Eingangssignal eingestellt werden. Vorteilhaft ist auch die folgende und andere Ersatzschaltungen.

Eine andere vorteilhafte Ausgestaltung des erfindungsgemäßen ΔΣ-Modulators sieht vor, dass die Elektronik ein Bandpassfilter, insbesondere ein digitales Filter, und einen Phasenschieber enthält, derart dass der elektromechanische ΔΣ-Modulator eine Bandpasscharakteristik mit einer Bandmittenfrequenz bei der Eigenfrequenz des schwingfähigen Systems aufweist. Vorteilhaft kann hierdurch ebenfalls die Bandbreite unabhängig vom Eingangssignal eingestellt werden. Vorteilhaft ist insbesondere eine digitale Ausführung der beiden vorgenannten Filter.

Eine weitere vorteilhafte Ausgestaltung sieht vor, dass die Elektronik Mittel zur Ableitung einer Schwingungsfrequenz des schwingfähigen Systems, insbesondere einen Phasenregelkreis enthält, mittels dessen die Bandmittenfrequenz gesteuert ist. Vorteilhaft wird durch diese Ausgestaltung beispielsweise die Phasendrehung des Tiefpasses mit Güteüberhöhung bei der Antriebsresonanzfrequenz unabhängig von Toleranzen im Herstellungsprozess. Hierdurch wird die Stabilität des ΔΣ-Modulators gesichert.

Eine besonders vorteilhafte Ausgestaltung des erfindungsgemäßen Delta-Sigma-Modulators sieht vor, dass der Digital-Analog-Umsetzer ein zentriertes pulsweitenmoduliertes Ausgangssignal aufweist, welches insbesondere zur Rückkopplung auf das schwingfähige System wirkt. Vorteilhaft ist dabei eine konstante Größe (Amplitude) des Rückkoppelsignals (der Rückkoppelspannung). Vorteilhaft ist weiterhin eine Quantisierung und Linearisierung des Rückkoppelsignals (der Rückkoppelkraft) des ΔΣ-Modulators im Zeitbereich. Vorteilhaft ist schließlich auch eine Zentrierung des Rückkoppelspannungspulses in der Art, dass der zeitliche Schwerpunkt des Impulses immer in der gleichen Taktphase liegt. Hierdurch werden Phasenverschiebungen der Schwingung des schwingfähigen Systems infolge unterschiedlicher Rückkoppelsignale vermieden.

Weitere vorteilhafte Ausgestaltungen sind den Unteransprüchen zu entnehmen.

### Zeichnung

Ausführungsbeispiele der Erfindung sind in der Zeichnung dargestellt und in der nachfolgenden Beschreibung näher erläutert.
Fig. 1 zeigt den Aufbau eines elektromechanischen ΔΣ-Modulators im Stand der Technik.
Fig. 2 zeigt ein mechanisches Sensorelement als Differentialkondensator.
Fig. 3 zeigt die Komparatorkennlinie eines Analog-Digital-Umsetzers.
Fig. 4 zeigt die analog-digital Übertragungsfunktion eines typischen oszillierenden Sensorelements mit Güteüberhöhung.
Fig. 5 zeigt den Aufbau eines elektromechanischen ΔΣ-Modulators mit Multibit-Wandlern.
Fig. 6 zeigt die Kennlinie eines Multibit-ADU.
Fig. 7 zeigt die Kennlinie eines Multibit-DAU.
Fig. 8 zeigt Verstärkungsfrequenzgänge in der Regelschleife einer Ausgestaltung des erfindungsgemäßen ΔΣ-Modulators.
Fig. 9 zeigt beispielhaft das ZPWM-Signal des Multibit-DAU in einer Ausgestaltung des erfindungsgemäßen ΔΣ-Modulators.

### Beschreibung von Ausführungsbeispielen

Anhand der im Folgenden beschriebenen Ausführungsformen soll die Erfindung detailliert dargestellt werden.

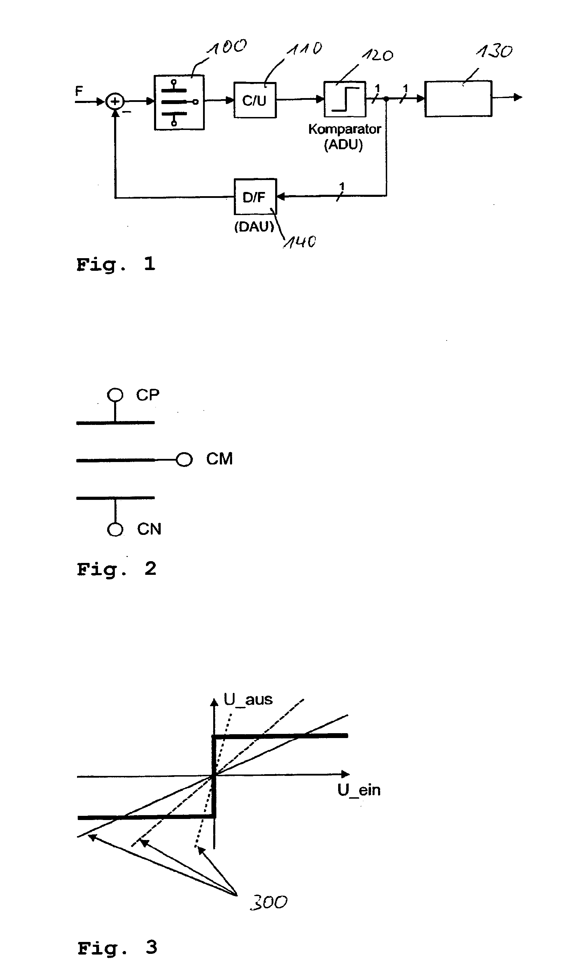

Fig. 1 zeigt den Aufbau eines elektromechanischen ΔΣ-Modulators im Stand der Technik. Bevor auf die Eigenschaften eingegangen wird, soll die Funktionsweise vorgestellt werden. In Fig. 1 ist das Blockschaltbild eines solchen Mikrosystems dargestellt. Es wirkt eine Kraft F auf einen mechanischen Schwinger 100, in diesem Beispiel auf ein Sensorelement. Diese Kraft F kann zum Beispiel die zu messende Größe in einem Beschleunigungssensor oder die Corioliskraft in einem Drehratensensor sein. Diese Kraft führt zu einer Kapazitätsänderung im Sensorelement 100, die von einem Kapazitäts-Spannungs-Wandler (C/U-Wandler) 110 in eine analoge Spannung gewandelt wird. Diese analoge Spannung wird als Eingangssignal von einem getakteten Komparator 120 (1-Bit-Analog-Digital-Umsetzer, ADU) mit einer einzigen Schwelle verglichen und somit ins Digitale gewandelt. Abhängig vom Ausgangssignal des Komparators 120 erzeugt ein mit gleicher Taktfrequenz laufender Digital-Analog-Umsetzer 140 (D/F, DAU) einen Kraftstoß. Der DAU 140 kann zwei mögliche Kraftstöße erzeugen. Beide Kraftstöße haben den gleichen Betrag. Sie unterscheiden sich lediglich in ihrem Vorzeichen. Um diesen Sachverhalt zu verdeutlichen, dient Fig. 2. Ein digitales Ausgangssignal des ΔΣ-Modulators wird einer digitalen Ausgangsschaltung 130 zugeleitet. Die Bezugszeichen 1 zeigen an, dass im Digitalteil des ΔΣ-Modulators alle Signale dieselbe Bitbreite aufweisen.

Fig. 2 zeigt einen mechanischen Schwinger in Form eines mechanischen Sensorelements 100 als Differentialkondensator. Dargestellt ist eine mittlere Elektrode CM zwischen zwei äußeren Elektroden CP und CN. Die mittlere Elektrode CM ist beweglich. Die äußeren Elektroden CP und CN sind ortsfest. Soll ein positiver Kraftstoß aufgebracht werden, so wird während eines vorgegebenen Zeitraumes eine konstante Spannung zwischen CP und CM angelegt. CM und CN sind kurzgeschlossen. Die hieraus resultierende elektrostatische Kraft zieht die mittlere Elektrode in Richtung CP. Bei einem negativen Kraftstoß wird über den gleichen Zeitraum die gleiche Spannung zwischen den Elektroden CM und CN angelegt. Die Elektroden CP und CM werden kurzgeschlossen. Der resultierende Kraftstoß zieht die mittlere Elektrode in Richtung CN. Eine Folge von Kraftstößen kompensiert im Mittel die zu messende Kraft F und die bewegliche Elektrode CM wird im Mittel in Ruhe gehalten.

Die wesentlichen Eigenschaften dieses Verfahrens sind im Folgenden aufgeführt:

Würde das Sensorelement 100 nicht durch die Elektronik mittels der durch den DAU 140 vermittels der Elektroden induzierten Kraftstöße geführt und somit gewissermaßen gefesselt, sondern könnte sich frei bewegen, so würde sich eine auslenkungsabhängige mechanische Federkonstante dieses Schwingers als Nichtlinearität im gesamten Meßsystem niederschlagen. Die Führung des Sensorelements 100 im elektromechanischen ΔΣ-Modulator verhindert also eine Auslenkung der Mittelmasse des mechanischen Schwingers und eliminiert somit die Gefahr einer Nichtlinearität durch das Sensorelement 100. Die mechanischen Eigenschaften des Sensorelements 100 werden also linearisiert.

Dadurch dass die im Mittel wirkende Rückstellkraft sich aus einzelnen Kraftstoß-Quanten zusammensetzt, die alle den gleichen Betrag haben und es nur zwei mögliche Rückkoppelkraftstöße gibt, ist die Kennlinie des Digital-Analog-Umsetzers DAU immer ideal linear. Durch zwei Punkte kann immer eine Gerade gezogen werden. Die Rückstellkraft wird also ebenfalls linearisiert. Fig. 3 verdeutlicht dies anhand der Komparatorkennlinie.

Fig. 3 zeigt die Komparatorkennlinie eines Analog-Digital-Umsetzers. Die Eingangsspannung U_ein des Analog-Digital-Umsetzers ADU wird mit einer einzigen Schwelle verglichen und die Ausgangsspannung U_aus des Analog-Digital-Umsetzers kann nur zwei Werte annehmen. Ist U_aus positiv, so wird ein positiver Kraftstoß zurückgekoppelt und umgekehrt. Im Gegenzug bringt die beschriebene Anordnung den Nachteil mit sich, dass die Steigung der Gerade in Fig. 3 nicht definiert ist. Um dies anzudeuten, sind drei Geraden 300 mit verschiedenen Steigungen in Fig. 3 eingezeichnet. Welche dieser drei Geraden 300 die Verstärkung des Analog-Digital-Umsetzers ADU wirklich beschreibt, hängt von der statistischen Verteilung der Spannung U_ein ab. Die Verstärkung der Reihenschaltung aus Analog-Digital-Umsetzer ADU und Digital-Analog-Umsetzer DAU ist also nicht definiert sondern hängt vom Eingangssignal des Analog-Digital-Umsetzers ADU ab, wie in der Schrift "Surface Micromachined Accelerometers", Bernhard E. Boser, Roger T. Howe, IEEE Journal of Solid State Circuits, Vol. 31, No. 3, March 1996 beschrieben. Dies resultiert in dem Nachteil einer Schleifenerstärkung (Verstärkung in der Regelschleife) im Delta-Sigma-Modulator, die abhängig vom Eingangssignal ist und somit nicht definiert eingestellt werden kann. Da die Bandbreite des ΔΣ-Modulators eine Funktion der Schleifenverstärkung ist, kann auch diese nicht eingestellt werden und ist signalabhängig. Die Bandbreite des Delta-Sigma-Modulators kann um mehrere Größenordnungen höher sein als die Bandbreite, die das Meßsystem überhaupt erfassen soll. Dies kann in einem großen Problem resultieren, wenn das mikromechanische Sensorelement störende Resonanzfrequenzen in einem Frequenzbereich hat, der auch durch die variable Bandbreite des ΔΣ-Modulators erfasst wird. Die Folge hieraus kann eine signalabhängige Instabilität des ΔΣ-Modulators sein, der das Produkt unbrauchbar macht.

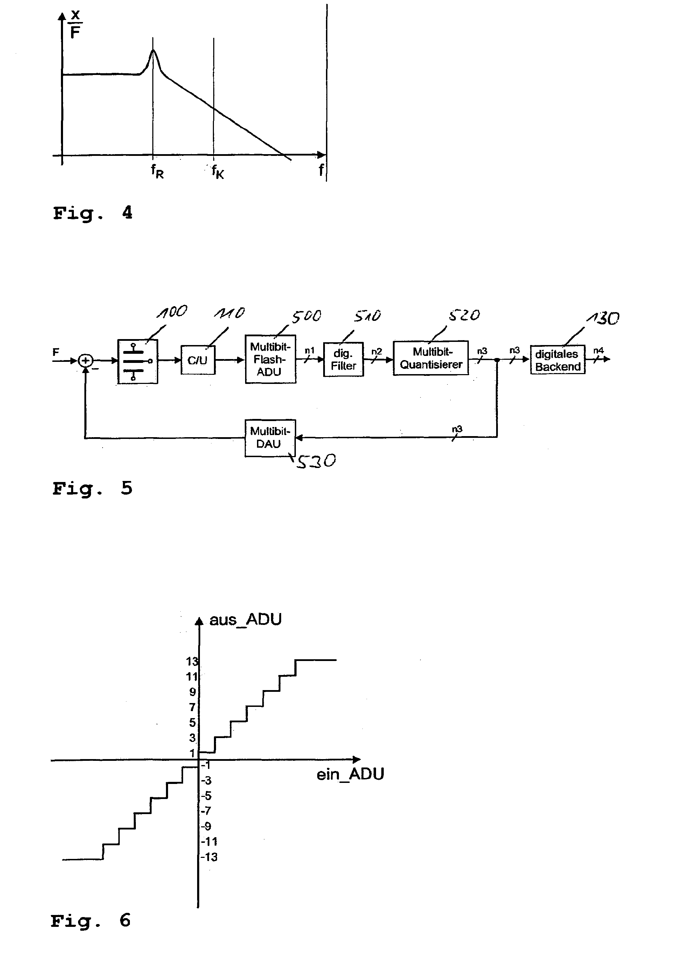

Fig. 4 zeigt die analog-digital Übertragungsfunktion eines typischen mechanischen Schwingers am Beispiel eines oszillierenden Sensorelements mit Güteüberhöhung. Der Analog-Digital-Umsetzer ADU quantisiert das analoge Eingangssignal in zwei mögliche Digitalwerte. Dieser Digitalwert entscheidet über die Polarität des rückgekoppelten Kraftstoßes. Das Sensorelement wird nun relativ hochfrequent mit Kraftstößen beaufschlagt und reagiert auf die Kraftstöße gemäß eines Integrierers zweiter Ordnung. In Fig. 4 ist die Übertragungsfimktion (Auslenkung x als Reaktion auf eine Kraft F) eines typischen Sensorelements mit Güteüberhöhung über der Frequenz f dargestellt. Die Kraftstöße werden mit einer Frequenz f_{K} auf das Sensorelement gegeben, die über der Sensorresonanzfrequenz f_{R}, der Eigenfrequenz des schwingfähigen Systems liegt. In diesem Frequenzbereich fällt die Kennlinie mit 40 dB pro Dekade. Die Auslenkung der Mittelmasse des Sensorelements stellt die Tiefpass gefilterte Reaktion auf eine Folge von Kraftstößen dar. Der aktuelle Quantisierungsfehler des Analog-Digital-Umsetzers ADU wird letztendlich auch im Sensorelement aufintegriert und beeinflusst wiederum die zukünftigen Entscheidungen des Analog-Digital-Umsetzers ADU. Über einen längeren Zeitraum werden die Quantisierungsfehler also durch das Sensorelement gefiltert. Das Quantisierungsrauschen wird geformt. Am Ausgang des Systems ist das Quantisierungsrauschen in dem Frequenzbereich am kleinsten in dem das Sensorelement die größte Verstärkung hat.

Je höher die Taktfrequenz desto breiter ist das Frequenzband auf welches sich die Quantisierungsrauschleistung verteilt. Daraus folgt, dass bei konstanter Quantisierungsrauschleistung die Rauschleistungsdichte in der Systembandbreite mit zunehmender Taktfrequenz abnimmt.

Eine Möglichkeit, einen hohen Signal-Rausch-Abstand zu erreichen, besteht darin, die Taktfrequenz zu erhöhen. Diese Möglichkeit stößt jedoch dann an Grenzen, wenn die Eingangsschaltung in den vorgegebenen Taktschlitzen nicht mehr einschwingen kann.

Eine weitere Möglichkeit, den Signal-Rausch-Abstand zu erhöhen, besteht darin, die Ordnung des Delta-Sigma-Modulators zu erhöhen. Dies bedeutet, durch frequenzselektive Schaltungen dafür zu sorgen, dass die Schleifenverstärkung im Bereich der Systembandbreite maximal ist und die Schleifenverstärkung außerhalb der Systembandbreite möglichst steil abfällt. Dieses Vorgehen birgt allerdings die große Gefahr, dass das System instabil werden kann, vor allem dann, wenn die Systembandbreite aufgrund eines 1-Bit-Analog-Digital-Umsetzers nur schwer dimensioniert werden kann und eventuelle Nichtidealitäten des Sensorelements zu Störresonanzen im Sensorelement führen, welche die Schleifenverstärkung ungünstig beeinflussen.

Da der ΔΣ-Modulator als geschlossener Regelkreis arbeitet, der die bewegliche Elektrode des Sensorelements immer wieder in die Ruhelage zurückregelt, sind Sensorelemente als Schwingungssysteme mit hoher mechanischer Güte betreibbar. Hierdurch kann ein hoher Signal-Rausch-Abstand erzielt werden.

Die implizite A/D-Umsetzung des ΔΣ-Prinzips bringt den Vorteil mit sich, dass das Ausgangssignal des ΔΣ-Modulators direkt digital weiterverarbeitet werden kann. Diese digitale Weiterverarbeitung bringt unter anderem die Vorteile, dass das Design sehr robust gegenüber elektromagnetischen Störungen ist, dass keine Langzeitdriften und Temperaturabhängigkeiten zu befürchten sind, dass sehr wenig externe Bauelemente benötigt werden und dass sehr große Zeitkonstanten realisierbar sind.

Eine Weiterentwicklung zu dem bisher beschriebenen Stand ist in der Schrift von C. Lang "Modellbildung und Realisierung eines rauscharmen elektromechanischen ΔΣ-Modulators zur Beschleunigungsmessung nach dem Prinzip der Kraftkompensation", Shaker-Verlag, Aachen, 2001, ISBN 3-8265-8616-6 am Beispiel eines Beschleunigungssensors veröffentlicht. Im Folgenden werden diejenigen Punkte aus der Schrift von C. Lang dargestellt, die für das Verständnis und die Einschätzung der im Rahmen dieser Erfindung beschriebenen Ideen wichtig sind. Zur Beschreibung der wesentlichen Punkte dient Fig. 5.

Fig. 5 zeigt den Aufbau eines elektromechanischen ΔΣ-Modulators mit Multibit-Wandlern. Die schematische Darstellung zeigt einen von Fig. 1 weiterentwickelten elektromechanischen ΔΣ-Modulator. Statt eines Komparators (1-Bit-ADU) 120 ist hier nun ein Flash-Multibit-ADU 500 vorgeschlagen. Dieser bietet den Vorteil, dass der Quantisierungsfehler der A/D-Umsetzung im Vergleich zum 1-Bit-ADU 120 verkleinert werden kann, wodurch ein kleineres Quantisierungsrauschen resultiert.

Ein weiterer Vorschlag im Stand der Technik besteht darin, ein Filter 510, insbesondere ein digitales Tiefpassfilter nach dem Multibit-ADU 500 einzusetzen. Dies bringt die Vorteile, dass das Quantisierungsrauschen des Digital-Analog-Umsetzers DAU bei tiefen Frequenzen stark geformt wird, wodurch der Signal-Rausch-Abstand bei kleinen Bandbreiten gesteigert werden kann. Ein weiterer Vorteil besteht darin, dass der Stromverbrauch des Filters sehr gering ist und dass das Filter sehr robust ist gegenüber Temperaturschwankungen und elektromagnetischen Störungen ist.

Ein weiterer Vorschlag im Stand der Technik besteht im Einsatz eines Multibit-DAU 530 gemäß Fig. 5. Dieser Wandler bietet die Vorteile, dass im Vergleich zum 1-Bit-Wandler der Quantisierungsfehler reduziert wird wodurch das Rauschen des Sensors entscheidend vermindert werden kann. Dies geschieht ohne Einbußen bezüglich der Linearität.

Die Erfindung im Unterschied zum Stand der Technik besteht darin, die Bandbreite des Delta-Sigma-Modulators so zu dimensionieren, dass sie nicht größer als erforderlich ist. Dies bringt den Vorteil, dass das Frequenzband in welchem störende Resonanzfrequenzen des Sensorelements wirken könnten, so klein wie möglich gehalten wird. Dies erhöht die Robustheit gegenüber Störmoden und deren Streuung im Sensorelement und auch gegenüber Fertigungstoleranzen in der Elektronik. Im Gegensatz zu der als Stand der Technik bezeichneten Tiefpaßcharakteristik des elektromechanischen ΔΣ-Modulators bedeutet dies, dass in dem Frequenzbereich von Null bis zur Antriebsresonanzfrequenz des Sensorelementes die Schleifenverstärkung des ΔΣ-Modulators gezielt so klein wie möglich eingestellt wird. Im Ergebnis erhält der elektromechanischen ΔΣ-Modulator eine Bandpaßcharakteristik.

Die Elektronik wird in einer ersten erfindungsgemäßen Ausgestaltung als Tiefpaß mit Güteüberhöhung bei der Antriebsresonanzfrequenz ausgeführt. Hierdurch wird das Quantisierungsrauschen des Digital-Analog-Umsetzers DAU im Bereich der Antriebsresonanzfrequenz besonders stark geformt. Statt eines Tiefpasses mit Resonanzüberhöhung kann in einer zweiten erfindungsgemäßen Ausgestaltung auch die Kombination aus einem Bandpaß, welcher die Mittenfrequenz bei der Antriebsresonanzfrequenz hat, und einem phasendrehenden Glied eingesetzt werden. Es können hier auch ganz allgemein Reglertypen eingesetzt werden, welche eine besonders große Verstärkung bei der Antriebsresonanzfrequenz haben.

Da ein Delta-Sigma-Modulator mit einem 1-Bit-Wandler eine signalabhängige Schleifenverstärkung und damit eine signalabhängige Bandbreite hat, ist solch ein Wandler nicht geeignet für die erfindungsgemäße Bandbreitenminimierung. Durch Einsatz eines Multibit-ADU wird die Verstärkung des Wandlers definiert und ist damit unabhängig vom Eingangssignal des Wandlers. Gleiches gilt für den Einsatz des Multibit-DAU.

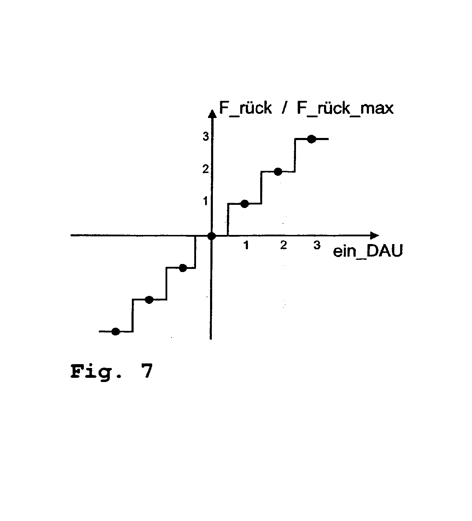

Fig. 6 zeigt die Kennlinie eines Multibit-ADU und Fig. 7 zeigt die Kennlinie eines Multibit-DAU. Die Figuren zeigen, dass die Wandler eine definierte Verstärkung haben. Man kann durch beide Wandlerkennlinien nur jeweils eine Gerade ziehen, um die Verstärkung zu beschreiben. Dies unterscheidet die Multibitwandler vom 1-Bit-Wandler (Komparator), bei welchem man durch die Kennlinie verschiedene Geraden mit verschiedenen Verstärkungen legen kann. Ein weiterer Vorteil der Multibitwandler besteht darin, dass die Abweichung von der Gerade, welche die Verstärkung beschreibt, deutlich kleiner ist als beim 1-Bit-Wandler. Die Abweichung von dieser Gerade wird auch als Quantisierungsfehler bezeichnet. Ein kleinerer Quantisierungsfehler bedeutet kleineres Quantisierungsrauschen. In Fig. 6 und Fig. 7 sind die Kennlinien der Umsetzer beispielhaft dargestellt.

Der Multibit Flash-Analog-Digital-Umsetzer wird vorteilhaft wie in der Schrift von C. Lang beschrieben realisiert.

Beim Multibit-Digital-Analog-Umsetzer (Multibit-DAU) wird im Folgenden zuerst auf die erfindungsgemäßen Anforderungen an den DAU und anschließend auf eine erfindungsgemäße Ausgestaltung des DAU eingegangen.

Die Aufgabe des Multibit-DAU ist die Bereitstellung eines Rückkoppelsignals welches zur Kompensation der zu messenden Corioliskraft verwendet wird.
Die Erfindung bezieht sich auf den Sachverhalt, dass diese Rückstellkraft durch die Elektrostatik im Sensorelement erzeugt wird und es Aufgabe der Elektronik ist, entsprechende Spannungen an das Sensorelement anzulegen. Hierbei besteht das Problem, dass der Zusammenhang zwischen Spannung und resultierender Kraft quadratisch ist. Es muss also eine Linearisierung erfolgen.

Ein weiterer Bestandteil der Erfindung ist der gezielte Einsatz eines Multibit-DAU, um dem Umsetzer eine definierte Verstärkung zuzuweisen und somit die Schleifenverstärkung und die Bandbreite des ΔΣ-Modulators definiert einstellen zu können und somit bezüglich Schleifenverstärkung und Bandbreite unabhängig vom Eingangssignal des ΔΣ-Modulators zu werden.

Die Forderungen nach Linearisierung und Multibit-Umsetzung können durch den im Folgenden beschriebenen erfindungsgemäßen Einsatz eines zentrierten pulsweitenmodulierten Signals (zentriertes PWM-Signal oder ZPWM-Signal) gelöst werden.

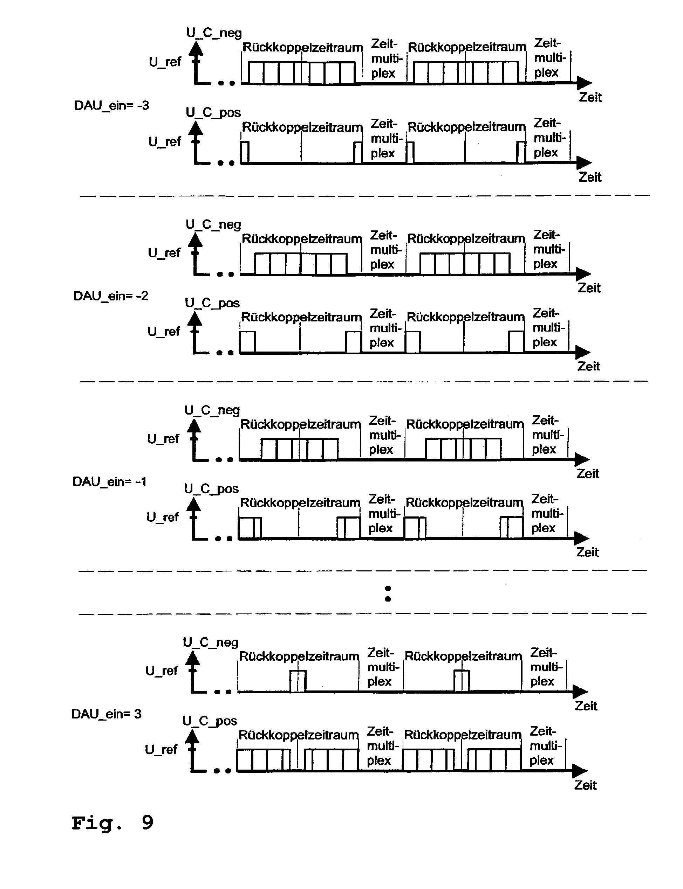

In Fig. 9 ist die Zuordnung zwischen den Ansteuerbits und den möglichen Rückkoppelsignalen dargestellt. Die Höhe der Rückkoppelspannung ist konstant; sowohl die Quantisierung als auch die Linearisierung findet im Zeitbereich statt. In Fig. 9 ist das Rückkoppelsignal des Delta-Sigma-Modulators über der Zeit aufgetragen. Die obere Teilfigur gilt für den Fall dass der Eingang des DAU den Wert DAU_ein=-3 annimmt. Der oberste Zeitstrahl beschreibt die Spannung U_C_neg an der Elektrode CN. Der zweite Zeitstrahl von oben beschreibt die Spannung U_C_pos an der Elektrode CP. In dem als "Rückkoppelzeitraum" bezeichneten Zeitabschnitt sind die genannten Signale gegenphasig. Während an einer der beiden Elektroden die Referenzspannung U_ref anliegt, ist die andere Elektrode mit der Mittelmasse kurzgeschlossen. Das zeitliche Integral über die während des Rückkoppelzeitraumes anliegende Spannung bestimmt die effektive Rückstellkraft. In dem als "Zeitmultiplex" beschriebenen Zeitabschnitt wird nicht rückgekoppelt. Dieser Zeitabschnitt kann für andere Zwecke, wie zum Beispiel das Messen der Auslenkung verwendet werden.
Die Figuren für DAU_ein=-2, DAU_ein=-1 und DAU_ein=3 zeigen die Verläufe der Rückkoppelspannungen für andere DAU-Eingangssignale. Die während des Rückkoppelzeitraumes anliegenden Spannungsverläufe U_C_neg und U_C_pos unterscheiden sich je nach dem Signal DAU_ein in der Länge der Zeitspanne für die die Spannung U_ref an das Sensorelement angelegt wird. Diese Zeitspanne ist im Zeitbereich quantisiert.
Das Eingangssignal des DAU wird periodisch aktualisiert. Dementsprechend sind die zu Rückkoppelzwecken an das Sensorelement angelegte Spannungen U_C_neg und U_C_pos ebenfalls in ein periodisches Muster eingebettet. Dieses Muster besteht immer aus einem "Rückkoppelzeitraum" konstanter Dauer und einem "Zeitmultiplexzeitraum" konstanter Dauer. In Abhängigkeit des Signals DAU_ein wird im Rückkoppelzeitraum lediglich die Aufteilung der Spannungspulse auf die beiden Rückkoppelelektroden variiert.

Eine weitere erfindungsgemäße Eigenschaft des Rückkoppel-PWM-Signals ist die Tatsache, dass es zentriert ist. Unabhängig von der Breite eines Rückkoppelimpulses ist der zeitliche Schwerpunkt des Impulses immer in der gleichen Taktphase. Hierdurch wird erreicht, dass der zeitliche Schwerpunkt des Rückkoppelimpulses nicht signalabhängig wird und somit keine signalabhängige Verfälschung des Rückkoppelsignals stattfinden kann. Es wird auf diese Weise vermieden, dass das Ausgangssignal des ΔΣ-Modulators nichtlinear wird.

Ein weiterer Vorteil der beschriebenen Vorgehensweise besteht darin, dass regelmäßig wiederkehrende Zeitschlitze freigehalten werden können, die man dazu nutzen kann, im Zeitmultiplex Funktionen zu realisieren, die unabhängig von der Rückkoppelfunktion sind.
Ein weiterer Unterschied zu der in der Schrift von C. Lang beschriebenen Multibit-Digital-Analog-Umsetzung besteht darin, dass nicht pro LSB der DA-Wandleransteuerung ein einzelner Impuls generiert wird (return to zero) sondern die LSB im ZPWM-Signal einfach aneinandergehängt werden (non-return to zero). Dies bringt den Vorteil, dass beim ZPWM-Signal die maximale Rückkoppelkraft größer ist als bei der in der Schrift von C. Lang beschriebenen Realisierung. Der Grund liegt darin, dass keine Rückkoppelzeit durch Rücksprünge auf Null verloren geht.

Ein weiterer Bestandteil der Erfindung ist der Einsatz eines Tiefpaßfilters mit Güteüberhöhung im elektromechanischen Delta-Sigma-Modulator. Statt dieses Tiefpasses könnte auch eine Kombination aus Bandpaß und Phasenschieber eingesetzt werden.

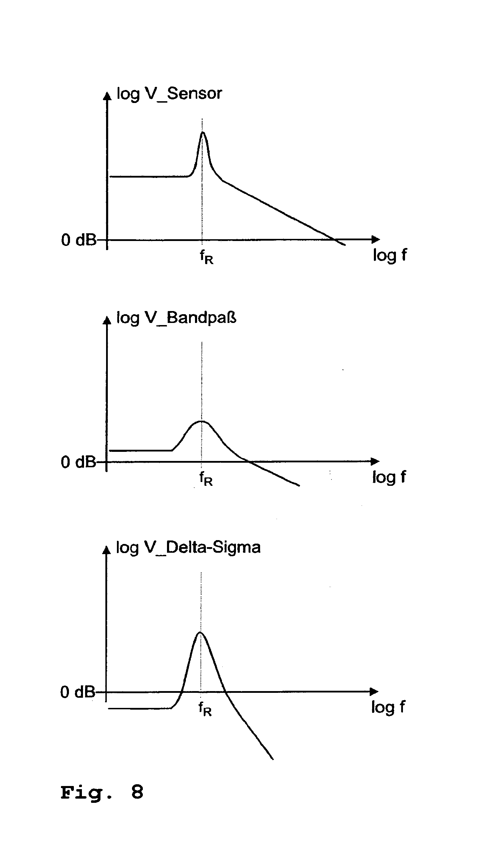

Allgemein kann ein Reglertyp eingesetzt werden, welcher im Bereich der Antriebsresonanzfrequenz eine Verstärkungsüberhöhung aufweist. Die Bandpaßcharakteristik des Filters bringt im Zusammenhang mit der Bandpaßcharakteristik des mechanischen Sensorelements den Vorteil, dass der Frequenzbereich, in welchem die Schleifenverstärkung des ΔΣ-Modulators größer als eins ist, beschränkt ist auf einen Frequenzbereich, welcher um die Sensorresonanzfrequenz zentriert ist und welcher möglichst schmal gewählt werden kann, um die Robustheit gegenüber störenden Resonanzmoden zu erhöhen. Außerdem findet eine starke Formung des DAU-Quantisierungsrauschens statt. Das Quantisierungsrauschen des ADU erfolgt durch die Mechanik. Diese Sachverhalte sind in Fig. 8 dargestellt.

Fig. 8 zeigt Verstärkungsfrequenzgänge in der Regelschleife einer Ausgestaltung des erfindungsgemäßen ΔΣ-Modulators. Auf den x-Achsen der Teilfiguren von Figur 8 ist die Frequenz in logarithmischem Maßstab aufgetragen. Die obere Teilfigur beschreibt den Betrag der Verstärkung vom Eingang des Sensorelementes 100 in Fig. 5. zu seinem Ausgang. Die mittlere Teilfigur beschreibt den Betrag der Verstärkung vom Eingang des digitalen Filters 510 in Fig. 5 zum Ausgang dieses digitalen Filters. Die untere Teilfigur beschreibt den Betrag der Verstärkung vom Eingang des Sensorelementes 100 in Fig. 5 zum Ausgang des digitalen Filters 510 in Fig. 5.

Die obere Teilfigur in Fig. 9 zeigt den Betrag der Übertragungsfunktion (Auslenkung als Funktion der Beschleunigung) des Sensorelementes. Man sieht die Resonanzüberhöhung bei der Resonanzfrequenz f_{R}. Die mittlere Teilfigur zeigt den Betrag des Verstärkungsganges des elektronischen Bandpasses in logarithmischem Maßstab. In der unteren Teilfigur ist der resultierende Verstärkungsgang zu sehen, welcher sich ergibt, wenn das Sensorelement und der elektronische Bandpaß in Reihe geschaltet sind. Bei der Sensorresonanzfrequenz wird durch die Kombination der beiden Verstärkungsgänge eine große Verstärkungsüberhöhung erreicht. In der geschlossenen Regelschleife des elektromechanischen Delta-Sigma-Modulators ist diese hohe Verstärkung dafür verantwortlich, dass das Quantisierungsrauschen des DAU am Ausgang des Delta-Sigma-Modulators im Bereich der Sensorresonanzfrequenz sehr stark unterdrückt wird.

Das Quantisierungsrauschen des ADU wird gemäß der in der oberen Teilfigur dargestellten Verstärkung des Sensorelementes unterdrückt. Es entsteht somit ein elektromechanischer ΔΣ-Modulator 4. Ordnung, der aus einer mechanischen Komponente 2. Ordnung (dem Sensorelement) und aus einer elektronischen Komponente 2. Ordnung (beispielsweise dem Tiefpaß mit Güteüberhöhung) besteht Dieser elektronische Tiefpaß mit Güteüberhöhung bringt zusätzliche Zustandsspeicher ins Mikrosystem, welche die Wirkung des DAU-Quantisierungsfehlers speichern können.

Die digitale Ausführung des Tiefpasses mit Güteüberhöhung bzw. der Ersatzlösungen (beispielsweise Bandpaß und Phasenschieber) führt zu dem Vorteil, dass Probleme hinsichtlich Langzeitdriften, elektromagnetischer Verträglichkeit (EMV) und Temperaturabhängigkeiten vermieden werden. Außerdem werden Ungenauigkeiten aufgrund von Prozesstoleranzen umgangen. Weiterhin ist das digitale Filter mit sehr geringer Verlustleistungsaufnahme realisierbar.

Ein weiterer Bestandteil der Erfindung besteht darin, die Taktfrequenz des Tiefpasses mit Güteüberhöhung bzw. der Ersatzlösungen (beispielsweise Bandpaß und Phasenschieber) direkt von der Antriebsresonanzfrequenz des Sensorelementes abhängig zu machen. Dies führt zu dem Vorteil, dass die Mittenfrequenz des Bandpasses immer genau auf der Antriebsresonanzfrequenz des Sensorelementes liegt, da sie automatisch nachgerührt wird. Dies hat wiederum zur Folge, dass eine optimale Rauschformung des DAU-Quantisierungsrauschens gewährleistet ist. Außerdem wird die Schleifenverstärkung und damit die Bandbreite des ΔΣ-Modulators unabhängig von Streuungen der Antriebsresonanzfrequenz des Sensorelementes.

Ein Vorteil des erfindungsgemäßen digitalen Filters besteht darin, dass die Phasendrehung des Tiefpasses mit Güteüberhöhung bzw. der Ersatzlösung bei der Antriebsresonanzfrequenz immer exakt dem entworfenen Wert entspricht. Die Gefahr von Streuungen zum Beispiel aufgrund von Toleranzen im Herstellungsprozess besteht nicht. Dies sichert die Stabilität des elektromechanischen ΔΣ-Modulators.

Die Erfindung ist nicht auf elektromechanische ΔΣ-Modulatoren, also ΔΣ-Modulatoren mit einem mechanischen Schwinger eingeschränkt. Denkbar sind auch andere schwingfähige Systeme als Bestandteil des erfindungsgemäßen ΔΣ-Modulators.

Es sind daneben auch weitere Ausführungsbeispiele denkbar.

## Patentansprüche

1. Delta-Sigma-Modulator,
- mit einem schwingfähigen System (100) mit einer Eigenfrequenz (f_{R}),
- mit einer Elektronik,
- wobei die Elektronik einen Multibit-Analog-Digital-Umsetzer (500) und einen Multibit-Digital-Analog-Umsetzer (530) beinhaltet,
- mit einer Regelschleife, die von dem schwingfähigen System (100) auf die Elektronik und von der Elektronik wieder auf das schwingfähige System (100) wirkt,
**dadurch gekennzeichnet, dass**
- die Elektronik Mittel zur Einstellung der Verstärkung in der Regelschleife beinhaltet, derart, dass die Verstärkung in der Regelschleife eine Verstärkungsüberhöhung in einem Frequenzbereich um die Eigenfrequenz (f_{R}) des schwingfähigen Systems (100) aufweist.

2. Delta-Sigma-Modulator nach Anspruch 1, **dadurch gekennzeichnet, dass** das schwingfähige System (100) mechanisch ausgestaltet ist.

3. Delta-Sigma-Modulator nach Anspruch 1 oder 2, **dadurch gekennzeichnet, dass** der Delta-Sigma-Modulator an einem Ausgang eine Bandpässcharakteristik aufweist.

4. Delta-Sigma-Modulator nach einem der vorhergehenden Ansprüche, **dadurch gekennzeichnet, dass** die Elektronik Mittel zur Einstellung der Bandbreite des Delta-Sigma-Modulators unabhängig von einem Eingangssignal des Analog-Digital-Umsetzers (140, 530) beinhaltet.

5. Delta-Sigma-Modulator nach einem der vorhergehenden Ansprüche, **dadurch gekennzeichnet, dass** die Elektronik Mittel zur Einstellung der Verstärkung in der Regelschleife beinhaltet, derart, dass die Verstärkung im Frequenzbereich zwischen Null und der Eigenfrequenz (f_{R}) minimal eingestellt ist.

6. Delta-Sigma-Modulator nach Anspruch 3, **dadurch gekennzeichnet, dass** die Elektronik des Delta-Sigma-Modulators ein Tiefpassfilter mit Güteüberhöhung, insbesondere ein digitales Filter enthält, derart dass der Delta-Sigma-Modulator eine Bandpasscharakteristik mit einer Bandmittenfrequenz bei der Eigenfrequenz (f_{R}) des schwingfähigen Systems (100) aufweist.

7. Delta-Sigma-Modulator nach Anspruch 3, **dadurch gekennzeichnet, dass** die Elektronik des Delta-Sigma-Modulators ein Bandpassfilter, insbesondere ein digitales Filter, und einen Phasenschieber enthält, derart dass der Delta-Sigma-Modulator eine Bandpasscharakteristik mit einer Bandmittenfrequenz bei der Eigenfrequenz (f_{R}) des schwingfähigen Systems (100) aufweist.

8. Delta-Sigma-Modulator nach Anspruch 6 oder 7, **dadurch gekennzeichnet, dass** die Elektronik Mittel zur Ableitung einer Schwingungsfrequenz des schwingfähigen Systems (100), insbesondere einen Phasenregelkreis enthält, mittels dessen die Bandmittenfrequenz gesteuert ist.

9. Delta-Sigma-Modulator nach Anspruch 1 oder 2, **dadurch gekennzeichnet, dass** der Digital-Analog-Umsetzer ein zentriertes pulsweitenmoduliertes Ausgangssignal aufweist, welches auf das schwingfähige System (100) wirkt.

## Claims

1. Delta-sigma modulator,
- having an oscillating system (100) with a natural frequency (f_{R}),
- having an electronics unit,
- wherein the electronics unit contains a multibit analogue/digital converter (500) and a multibit digital/analogue converter (530),
- having a control loop which acts on the electronics unit from the oscillating system (100) and on the oscillating system (100) again from the electronics unit,
**characterized in that**
- the electronics unit contains means for adjusting the gain in the control loop such that the gain in the control loop peaks in a frequency range around the natural frequency (f_{R}) of the oscillating system (100).

2. Delta-sigma modulator according to Claim 1, **characterized in that** the oscillating system (100) is in mechanical form.

3. Delta-sigma modulator according to Claim 1 or 2, **characterized in that** the delta-sigma modulator has a bandpass characteristic at an output.

4. Delta-sigma modulator according to one of the preceding claims, **characterized in that** the electronics unit contains means for adjusting the bandwidth of the delta-sigma modulator independently of an input signal for the analogue/digital converter (140, 530).

5. Delta-sigma modulator according to one of the preceding claims, **characterized in that** the electronics unit contains means for adjusting the gain in the control loop such that the gain is set to minimum in the frequency range between zero and the natural frequency (f_{R}).

6. Delta-sigma modulator according to Claim 3, **characterized in that** the electronics unit of the delta-sigma modulator contains a low-pass filter with peak quality, particularly a digital filter, such that the delta-sigma modulator has a bandpass characteristic with a band centre frequency at the natural frequency (f_{R}) of the oscillating system (100).

7. Delta-sigma modulator according to Claim 3, **characterized in that** the electronics unit of the delta-sigma modulator contains a bandpass filter, particularly a digital filter, and a phase shifter such that the delta-sigma modulator has a bandpass characteristic with a band centre frequency at the natural frequency (f_{R}) of the oscillating system (100).

8. Delta-sigma modulator according to Claim 6 or 7, **characterized in that** the electronics unit contains means for deriving an oscillation frequency for the oscillating system (100), particularly a phase locked loop, which is used to control the band centre frequency.

9. Delta-sigma modulator according to Claim 1 or 2, **characterized in that** the digital/analogue converter has a centred pulse-width-modulated output signal which acts on the oscillating system (100).

## Revendications

1. Modulateur Delta-Sigma,
- comprenant un système oscillant (100) avec une fréquence de résonance (f_{R}),
- comprenant un circuit électronique,
- le circuit électronique comprenant un convertisseur analogique/numérique à bits multiples (500) et un convertisseur numérique/analogique à bits multiples (530),
- comprenant une boucle de régulation qui agit du système oscillant (100) sur le circuit électronique et du circuit électronique de nouveau sur le système oscillant (100), **caractérisé en ce que**
- le circuit électronique comprend des moyens pour régler l'amplification dans la boucle de régulation de telle sorte que l'amplification dans la boucle de régulation présente une intensification de l'amplification dans une plage de fréquences autour de la fréquence de résonance (f_{R}) du système oscillant (100).

2. Modulateur Delta-Sigma selon la revendication 1, **caractérisé en ce que** le système oscillant (100) est de configuration mécanique.

3. Modulateur Delta-Sigma selon la revendication 1 ou 2, **caractérisé en ce que** le modulateur Delta-Sigma présente à une sortie une caractéristique passe-bande.

4. Modulateur Delta-Sigma selon l'une des revendications précédentes, **caractérisé en ce que** le circuit électronique contient des moyens pour régler la bande passante du modulateur Delta-Sigma indépendamment d'un signal d'entrée du convertisseur analogique/numérique (140, 530).

5. Modulateur Delta-Sigma selon l'une des revendications précédentes, **caractérisé en ce que** le circuit électronique contient des moyens pour régler l'amplification dans la boucle de régulation de telle sorte que l'amplification est réglée au niveau minimum dans la plage de fréquences entre zéro et la fréquence de résonance (f_{R}).

6. Modulateur Delta-Sigma selon la revendication 3, **caractérisé en ce que** le circuit électronique du modulateur Delta-Sigma présente un filtre passe-bas avec intensification de la qualité, notamment un filtre numérique, de sorte que le modulateur Delta-Sigma présente une caractéristique de bande passante ayant une fréquence de milieu de bande au niveau de la fréquence de résonance (f_{R}) du système oscillant (100).

7. Modulateur Delta-Sigma selon la revendication 3, **caractérisé en ce que** le circuit électronique du modulateur Delta-Sigma présente un filtre passe-bande, notamment un filtre numérique, et un déphaseur de sorte que le modulateur Delta-Sigma présente une caractéristique de bande passante ayant une fréquence de milieu de bande au niveau de la fréquence de résonance (f_{R}) du système oscillant (100).

8. Modulateur Delta-Sigma selon la revendication 6 ou 7, **caractérisé en ce que** le circuit électronique contient des moyens pour dériver une fréquence d'oscillation du système oscillant (100), notamment un circuit régulateur de phase au moyen duquel est commandée la fréquence de milieu de bande.

9. Modulateur Delta-Sigma selon la revendication 1 ou 2, **caractérisé en ce que** le convertisseur numérique/analogique présente un signal de sortie modulé en largeur d'impulsion centré qui agit sur le système oscillant (100).
